# EUROPEAN PATENT SPECIFICATION

(11) **EP 1 531 661 B1**
(45) Date of publication and mention of the grant of the patent: **05.04.2006**
(21) Application number: 04026688.4
(22) Date of filing: 10.11.2004
(51) Int. Cl.: H05K 7/20, H05K 5/00

(54) **Circuit assembly and method for producing the same**
Zusammenbau einer Schaltungsanordnung und Herstellungsverfahren dafür
Assemblage d'un dispositif avec circuits et méthode pour le réaliser

(30) Priority: 11.11.2003 JP 2003381400
(43) Date of publication of application: 18.05.2005
(73) Proprietor: Sumitomo Wiring Systems, Ltd., Yokkaichi-City, Mie, 510-8503 (JP)
(72) Inventor: Nakanishi, Ryuji c/o Sumitomo Wiring Systems, Ltd., Yokkaichi-City, Mie, 510-8503 (JP)
(74) Representative: Winter, Brandl, Fürniss, Hübner Röss, Kaiser, Polte Partnerschaft Patent- und Rechtsanwaltskanzlei

(56) References cited:
- EP-A- 0 883 332
- EP-B- 0 625 871
- US-A- 4 675 784
- US-A- 6 088 227
- US-A1- 2003 137 813
- PATENT ABSTRACTS OF JAPAN vol. 2000, no. 20, 10 July 2001 (2001-07-10) & JP 2001 081418 A (POLYMATECH CO LTD), 27 March 2001 (2001-03-27)

## Description

This invention relates to a circuit assembly including a circuit section constituting an electrical power circuit, a heat radiation member, and an insulation layer interposed between the circuit section and the heat radiation member, and relates to a method for producing the circuit assembly.

Heretofore, an electrical junction box, in which a plurality of bus bars constitute a distribution circuit and a switching device is installed, has been generally known as means for distributing an electrical power from a common electrical source on a vehicle to respective electronic units. Furthermore, means for downsizing the electrical junction box have been developed recently. For example, Japanese Patent Publication No. 2003-164039 discloses a method for producing a circuit assembly corresponding to a downsized electrical junction box. The method for producing the circuit assembly comprises the steps of: forming a distribution circuit by a plurality of bus bars; providing a semiconductor switching-device in an electrical power circuit; bonding the bus bars and a control circuit substrate for controlling actuation of the semiconductor switching-device to each other to form a circuit section; mounting a casing on the circuit section at the side of the control circuit substrate; and adhering a heat radiation member to the circuit section at the bus bar side.

In order to positively insulate the circuit section from the heat radiation member when bonding them, an insulation adhesive is applied to a bonding surface of the heat radiation member, and is dried to form an insulation layer. Then, an insulation adhesive is applied to the insulation layer or the circuit section at the bus bar side to bond the circuit section and heat radiation member to each other. Thus, after forming the insulation layer with a given thickness by solidifying the initially applied insulation adhesive, an insulation adhesive is further applied to the insulation layer to bond the circuit section on the heat radiation member. Consequently, it is possible to ensure a minimum thickness of the insulation layer by the initial insulation layer, even if a force for pressing the circuit section is slightly over a given value upon bonding.

However, although such a method of bonding the circuit section on the heat radiation member can ensure a thickness of the insulation layer between the circuit section and the heat radiation member, the adhesive applying step must be carried out twice and the respective steps require a time for solidifying the adhesive. This will lower efficiency in working and increase a cost in production.

In view of the above problems, an object of the present invention is to provide a circuit assembly in which an insulation layer is easily formed between a circuit section and a heat radiation member and a thickness of the insulation layer can be ensured by a simple structure and to provide a method for producing the circuit assembly.

This problem is solved by a method according to Claim 1 and a circuit assembly according to Claim 3 respectively.

The invention specified in Claim 1 is directed to a method for producing a circuit assembly by adhering a circuit section constituting an electrical power circuit to a bonding surface of a heat radiation member. The method comprises the steps of: applying an insulation adhesive to the bonding surface of the heat radiation member; superposing an insulation sheet-like element on the insulation adhesive before the insulation adhesive is solidified, the insulation sheet-like element having numerous flow paths through which the insulation adhesive can pass in a thickness direction of the element; and superposing the circuit section on the insulation sheet-like element and pressing the circuit section toward the bonding surface. Consequently, the circuit section and heat radiation member are bonded to each other by the insulation adhesive seeping through the insulation sheet-like element.

In a preferred embodiment of the present invention as specified in Claim 2 an insulation sheet-like element having numerous flow paths is selected from a sheet-like material made by braiding insulation fibers in the element-superposing step.

A circuit assembly according to the present invention includes a circuit section constituting an electrical power circuit and a heat radiation member having a bonding surface to which the circuit section is adhered. The circuit assembly is characterized in that: an insulation sheet-like element has numerous flow paths through which the insulation adhesive can pass in a thickness direction of the element; the insulation sheet-like element is interposed between the bonding surface of the heat radiation member and the circuit section; and the circuit section is adhered to the bonding surface.

In a preferred embodiment of the present invention as specified in Claim 4 the insulation sheet-like element having numerous flow paths is selected from a sheet-like material made by braiding insulation fibers.

According to one embodiment of the invention the insulation adhesive is applied to the bonding surface of the heat radiation member. The insulation sheet-like element has the numerous flow paths through which the insulation adhesive can pass in a thickness direction of the element. The insulation sheet-like element is superposed on the insulation adhesive before the insulation adhesive is solidified. The circuit section is superposed on the insulation sheet-like element. The circuit section is pressed toward the bonding surface, thereby bonding the circuit section and heat radiation member by the insulation adhesive. Accordingly, even if a layer of the insulation adhesive is collapsed by a relatively great pressure onto the circuit section, it is possible to ensure a minimum thickness of the adhesive layer through the insulation sheet-like element interposed between the circuit section and the bonding surface by a work of applying the adhesive to the bonding surface only at one time. Also, since the numerous flow paths that can pass the adhesive are formed in the insulation sheet-like element, the insulation adhesive can be uniformly applied to the bonding surface of the circuit section stacked on the insulation sheet-like element and the bonding between the circuit section and the heat radiation member can be positively obtained through the insulation sheet-like element.

According to another embodiment of the invention, the insulation sheet-like element is selected from a sheet-like material made by braiding insulation fibers, so that the numerous flow paths that can pass the insulation adhesive in the thickness direction can be formed uniformly over the whole surface of the insulation sheet-like element. Since a diameter of the fiber determines a size of the flowing path, the insulation adhesive passes the flowing path and flows behind an upper surface of the fiber or an upper surface of the insulation sheet-like element, thereby enhancing the bonding between the circuit section and the heat radiation member.

According to another embodiment of the invention, since the insulation sheet-like element is interposed between the circuit section and the heat radiation member, the circuit assembly can positively ensure a thickness of an insulation adhesive in comparison with an insulation layer formed by solidifying the adhesive in the prior art. Accordingly, it is possible to enhance reliability in insulation between the circuit section and the heat radiation member.

Further objects, features and advantages of the present invention can be seen from the depending claims and the description of exemplary embodiments of the present invention. Thereto:
Figure 1 is an exploded perspective view of a circuit assembly produced by a method in accordance with one embodiment of the present invention;
Figure 2 is a perspective view of a heat radiation member in accordance with one embodiment of the present invention, illustrating the heat radiation member applied with an insulation adhesive; and
Figure 3 is a perspective view of the heat radiation member shown in Figure 2, illustrating an insulation sheet-like element being stacked onto the insulation adhesive on the heat radiation member.

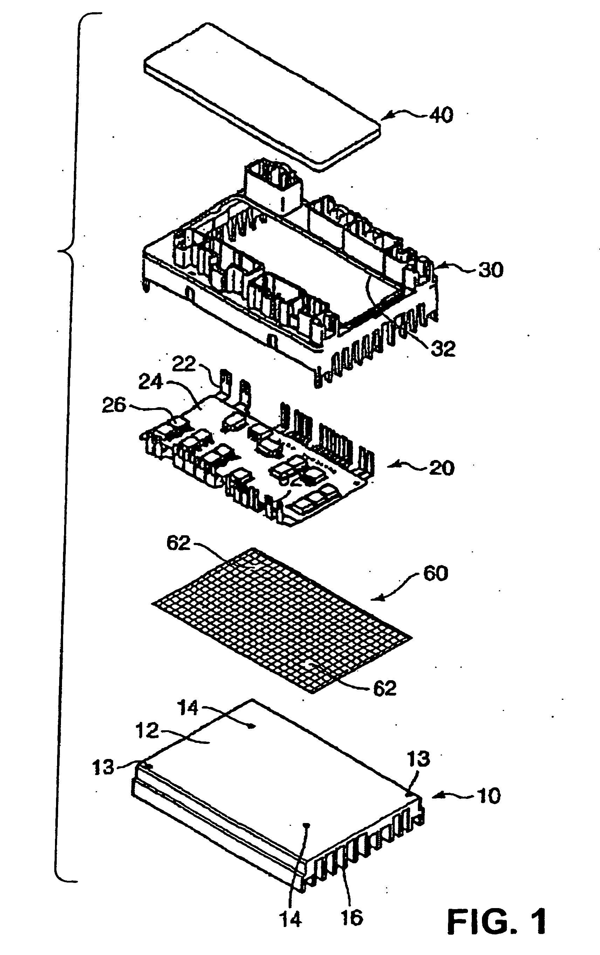

Figure 1 is an exploded perspective view of a circuit assembly produced by a method in accordance with one embodiment of the present invention. The circuit assembly includes a circuit section 20 constituting an electrical power circuit, a heat radiation member 10 having a bonding surface to which the circuit section 20 is adhered, a casing 30 surrounding the circuit section 20, and a cover 40 to be mounted on an opening 32 in the casing 30. An insulation sheet-like element 60 is disposed between the circuit section 20 and the heat radiation member 10.

The circuit section 20 includes a plurality of bus bars 22 constituting a distribution circuit and a control circuit substrate 24 for actuating semiconductor switching-devices 26 provided in the electrical power circuit. The bus bars 22 are adhered to the control circuit substrate 24. Electronic components such as the semiconductor switching-devices 26 and resistance devices are mounted on the circuit section 20.

The heat radiation member 10 is provided on the surface opposite from the bonding surface 12 with a plurality of fins 16. The bonding surface 12 is a rectangular shape and is provided in diagonal positions on the outer peripheral edge with holes 13 for recognition in image processing. The bonding surface 12 is also provided in inner positions from the outer peripheral edge with positioning holes 14 for positioning the sheet-like element 60 on the surface 12.

The insulation sheet-like element 60 is selected from a sheet-like material made by braiding insulation fibers such as glass fibers. The sheet-like material made of braided insulation fibers has numerous clearances between the fibers. An insulation adhesive 50 described after is applied uniformly on the whole surface of the insulation sheet-like element 60 to flow into the clearances that define adhesive flow paths. The insulation sheet-like element 60 is provided with positioning holes 62 at the positions corresponding to the positioning holes 14 in the heat radiation member 10 when the element 60 is stacked on the bonding surface 12 of the heat radiation member 10.

The circuit section 20 is adhered to the heat radiation member 10 with the insulation sheet-like element 60 being disposed between the circuit section 20 and the bonding surface 12 of the heat radiation member 10. The casing 30 and cover 40 are mounted on the circuit section 20 to produce the circuit assembly.

Next, a concrete method for adhering the circuit section 20 to the heat radiation member 10 while interposing the insulation sheet-like element 60 between the heat radiation member 10 and the circuit element 20 will be explained below.

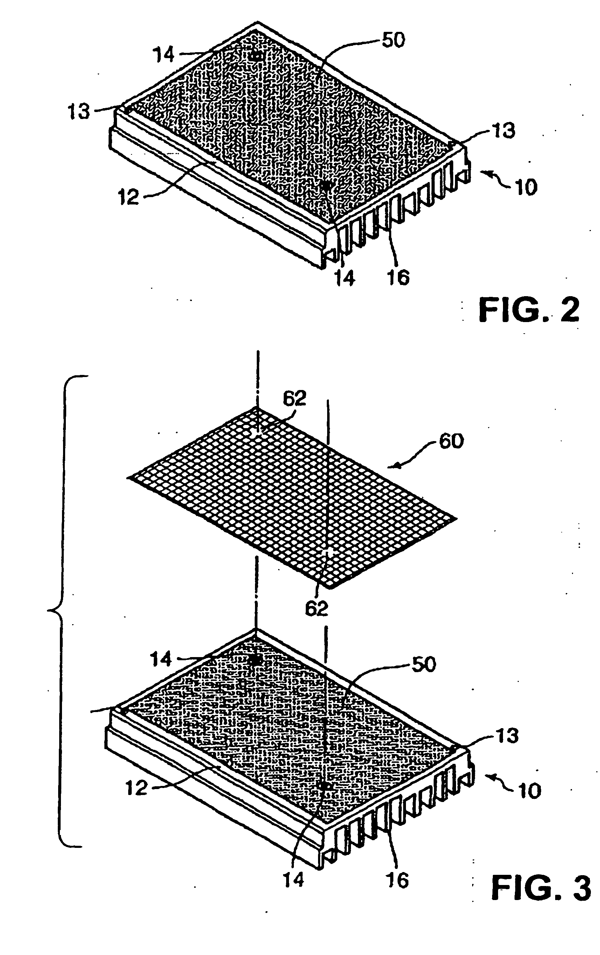

Firstly, as shown in Figure 2, the insulation adhesive 50 is applied to the bonding surface 12 of the heat radiation member 10. It should be noted that the insulation adhesive 50 is not applied to the positioning holes 14 for positioning the insulation sheet-like element 60 when applying the insulation adhesive 50 to the bonding surface 12. A screen-printing method will be preferable in applying the insulation adhesive since the method can easily distinguish an application area from a non-application area.

It will be possible to apply the insulation adhesive 50 to the holes 13 correctly by utilizing a screen-printing machine, which can automatically position a work and a screen so that the insulation sheet-like element 60 accords with the heat radiation member 10 while recognizing the holes 13 in the bonding surface 12 of the heat radiation member 10 by means of image processing.

Next, the insulation sheet-like element 60 is superposed on the insulation adhesive 50 before the insulation adhesive 50 is solidified. Since the insulation sheet-like element 60 is provided with the positioning holes 62 at the positions corresponding to the positioning holes 14 in the bonding surface 12 of the heat radiation member 10, as shown in Figure 3, it is possible to superpose the insulation sheet-like element 60 on the insulation adhesive 50 while recognizing visually to accord the positioning holes 62 in the insulation sheet-like element 60 with the positioning holes 14 in the heat radiation member 10.

It is possible to position the insulation sheet-like element 60 and heat radiation member 10 by inserting a pin into each positioning hole 14 in the member 10 and receiving the pin in each positioning hole 62 in the insulation sheet-like element 60 as well as the visual positioning described above.

After superposing the insulation sheet-like element 60 on the insulation adhesive 50, the insulation adhesive 50 will seep through the numerous clearances or flow paths in the element 60 by a self-weight of the element 60 or a light pressure onto the element 60. In order to seep the insulation adhesive 50 through the flow paths in the insulation sheet-like element 60, it is preferable to set a thickness of the element 60 to be smaller than a thickness of the applied insulation adhesive 50 on the bonding surface 12. For example, if a thickness of the applied insulation adhesive 50 is 0.2 mm and a thickness of the insulation sheet-like element 60 is 0.1 mm, it is possible to seep the insulation adhesive 50 through the flow paths in the element 60 over the surface facing the circuit section 20.

The circuit section 20 will be closely disposed on the insulation adhesive 50 seeped through the insulation sheet-like element 60 by superposing the insulation sheet-like element 60 on the circuit section 20 and pressing the element 60 onto the bonding surface 12.

Finally, when the insulation adhesive 50 is solidified (for example, an epoxy base adhesive is solidified by heating), the circuit section 20 will be adhered to the heat radiation member 10 with the insulation sheet-like element 60 being interposed between them.

Even if a layer of the insulation adhesive 50 is collapsed by a relatively high pressure onto the circuit section 20 when the circuit section 20 is adhered to the heat radiation member 10, it is possible to ensure a minimum thickness of the insulation adhesive 50 through the insulation sheet-like element 60 interposed between the circuit section 20 and the bonding surface 12 by a work of applying the insulation adhesive 50 to the bonding surface 12 only at one time. Also, since the numerous flow paths that can pass the insulation adhesive 60 are formed in the insulation sheet-like element 60, the insulation adhesive 50 can be uniformly applied to the bonding surface of the circuit section 20 stacked on the insulation sheet-like element 60 and the positive bonding between the circuit section 20 and the heat radiation member 10 can be obtained through the insulation sheet-like element 60.

The insulation sheet-like element 60 can be selected from a sheet-like material made by braiding the insulation fibers, so that the numerous flow paths that can pass the insulation adhesive 50 in the thickness direction can be formed uniformly over the whole surface of the insulation sheet-like element 60. Since a diameter of the fiber determines a size of the flowing path, the insulation adhesive 50 passes the flowing path and flows behind an upper surface of the fiber or an upper surface of the insulation sheet-like element 60, thereby enhancing the bonding between the circuit section 20 and the heat radiation member 10.

Since the circuit assembly constructed above interposes the insulation sheet-like element 60 between the circuit section 20 and the heat radiation member 10, the circuit assembly can ensure a thickness of an insulation adhesive in comparison with an insulation layer formed by solidifying the insulation adhesive in the prior art. Accordingly; it is possible to enhance reliability in insulation between the circuit section 20 and the heat radiation member 10.

In the above embodiment, the insulation adhesive 50 seeps through the insulation sheet-like element 60 when the insulation sheet-like element 60 is stacked on the insulation adhesive 50 and the circuit section 20 is adhered to the heat radiation member 10 when the circuit section 20 is mounted on the insulation sheet-like element 60. However, the insulation adhesive 50 is not forcedly seeped through the insulation sheet-like element 60 when the element 60 is superposed on the insulation adhesive 50 rather, the insulation adhesive 50 may seep through the insulation sheet-like element 60 by a pressure exerted when the circuit section 20 is pushed onto the insulation sheet-like element 60.

The insulation sheet-like element 60 is not limited to a sheet-like material made of the braided fibers. For example, it is possible to use a thin sheet made of an epoxy resin material and pressed in such a way as to provide numerous apertures as flow paths.

Since it is possible to position the insulation sheet-like element 60 and heat radiation member 10 by guiding them along the their outer shapes when the element 60 is stacked on the heat radiation member 10, the positioning holes 14 and 62 formed in them in the above embodiment may be eliminated.

The insulation adhesive 50 is not necessarily applied to the bonding surface 12 of the heat radiation member 10 by screen-printing. The circuit assembly of the present invention can be produced by a manually applying work of the insulation adhesive.

## Claims

1. Method for producing a circuit assembly by adhering a circuit section (20) constituting an electrical power circuit to a bonding surface (12) of a heat radiation member (10), said method comprising the steps of:
applying an insulation adhesive (50) to said bonding surface of said heat radiation member;
superposing an insulation sheet-like element (60) on said insulation adhesive before said insulation adhesive is solidified, said insulation sheet-like element having numerous flow paths through which said insulation adhesive can pass in a thickness direction of said element; and
superposing said circuit section on said insulation sheet-like element and pressing said circuit section toward said bonding surface;
whereby said circuit section and heat radiation member are bonded to each other by said insulation adhesive seeping through said insulation sheet-like element.

2. Method for producing a circuit assembly according to Claim 1, wherein said insulation sheet-like element having numerous flow paths is selected from a sheet-like material made by braiding insulation fibers in said element-superposing step.

3. Circuit assembly including a circuit section (20) constituting an electrical power circuit and a heat radiation member (10) having a bonding surface (12) to which said circuit section is adhered, by an insulating adhesive (50),
said circuit assembly being **characterized in that**: an insulation sheet-like element (60) having numerous flow paths through which said insulation adhesive can pass in a thickness direction of said element is interposed between said bonding surface of said heat radiation member and said circuit section.

4. Circuit assembly according to Claim 3, wherein said insulation sheet-like element having numerous flow paths is selected from a sheet-like material made by braiding insulation fibers.

## Patentansprüche

1. Verfahren zum Herstellen eines Schaltungsaufbaus, indem man einen Schaltungsbereich (20), der eine Schaltung für elektrische Leistung bildet, an eine Klebeoberfläche (12) eines Mittels zur Wärmeabstrahlung (10) klebt, wobei das Verfahren die folgenden Schritte umfasst:
Aufbringen eines isolierenden Klebstoffes (50) auf die Klebeoberfläche des Mittels zur Wärmeabstrahlung;
Anordnen eines isolierenden plattenartigen Elements (60) auf dem isolierenden Klebstoff, bevor sich der isolierenden Klebstoff verfestigt, wobei das isolierende plattenartige Element mehrere Strömungswege aufweist, durch die der isolierende Klebstoff fließen kann, und zwar in einer Richtung der Dicke des Elements; und
Anordnen des Schaltungsbereichs auf dem isolierenden plattenartigen Element und Pressen des Schaltungsbereichs in Richtung auf die Klebeoberfläche;
wodurch der Schaltungsbereich und das Mittel zur Wärmeabstrahlung gegenseitig miteinander durch den isolierenden Klebstoff verklebt werden, der durch das isolierende plattenartige Element dringt.

2. Verfahren zum Herstellen eines Schaltungsaufbaus nach Anspruch 1, wobei das isolierende plattenartige Element, das mehrere Strömungswege aufweist, aus einem plattenartigen Material ausgewählt ist, welches **dadurch** hergestellt wird, dass man isolierende Fasern in dem Schritt des Anordnens des Elements verflechtet.

3. Schaltungsaufbau, der einen Schaltungsbereich (20) umfasst, der eine Schaltung für elektrische Leistung bildet, sowie ein Mittels zur Wärmeabstrahlung (10), welches eine Klebeoberfläche (12) aufweist, an die der Schaltungsbereich mittels eines isolierenden Klebstoffes geklebt ist,
wobei der Schaltungsaufbau **dadurch gekennzeichnet ist, dass**:
ein isolierendes plattenartiges Element (60), das mehrere Strömungswege aufweist, durch die der isolierende Klebstoff fließen kann, und zwar in einer Richtung der Dicke des Elements, zwischen der Klebeoberfläche des Mittels zur Wärmeabstrahlung und dem Schaltungsbereich angeordnet ist.

4. Schaltungsaufbau nach Anspruch 3, wobei das isolierende plattenartige Element (60), das mehrere Strömungswege aufweist, aus einem plattenartigen Material ausgewählt ist, welches **dadurch** hergestellt wird, indem man isolierende Fasern verflechtet.

## Revendications

1. Procédé pour produire un assemblage de circuits en collant une section de circuit (20) constituent un circuit de courant électrique sur une surface de liaison (12) d'un élément de rayonnement de chaleur (10), ledit procédé comprenant les étapes consistant à:
appliquer un adhésif isolant (50) sur ladite surface de liaison dudit élément de rayonnement de chaleur;
superposer un élément isolant en forme de feuille (60) sur ledit adhésif isolant avant que ledit adhésif isolant soit solidifié, ledit élément isolant en forme de feuille comprenant de nombreux chemins d'écoulement à travers lesquels ledit adhésif isolant peut passer dans le sens de l'épaisseur dudit élément; et
superposer ladite section de circuit sur ledit élément isolant en forme de feuille et presser ladite section de circuit en direction de ladite surface de liaison;
dans lequel ladite section de circuit et ledit élément de rayonnement de chaleur sont liés l'un à l'autre par ledit adhésif isolant s'infiltrant à travers ledit élément isolant en forme de feuille.

2. Procédé pour produire un assemblage de circuits selon la revendication 1, dans lequel ledit élément isolant en forme de feuille comprenant de nombreux chemins d'écoulement est sélectionné à partir d'une matière en forme de feuille constituée en tressant des fibres d'isolation lors de ladite étape de superposition d'élément.

3. Assemblage de circuits comprenant une section de circuit (20) constituant un circuit de courant électrique et un élément de rayonnement de chaleur (10) présentant une surface de liaison (12) sur laquelle ladite section de circuit est collée à l'aide d'un adhésif isolant (50),
ledit assemblage de circuits étant **caractérisé en ce que**:
un élément isolant en forme de feuille (60) comprenant de nombreux chemins d'écoulement à travers lesquels ledit adhésif isolant peut passer dans le sens de l'épaisseur dudit élément est interposé entre ladite surface de liaison dudit élément de rayonnement de chaleur et ladite section de circuit.

4. Assemblage de circuits selon la revendication 3, dans lequel ledit élément isolant en forme de feuille comprenant de nombreux chemins d'écoulement est sélectionné à partir d'une matière constituée en tressant des fibres d'isolation.
